# EUROPEAN PATENT SPECIFICATION

(11) **EP 4 159 670 B1**
(45) Date of publication and mention of the grant of the patent: **15.10.2025**
(21) Application number: 21918556.8
(22) Date of filing: 15.01.2021
(51) Int. Cl.: B82B 1/00, B82B 3/00, B82Y 30/00, B82Y 40/00, H01J 1/304, B81C 1/00, H01J 37/073

(54) **FUNCTIONALIZED CARBON NANOCONE TIP AND PREPARATION METHOD THEREFOR**
FUNKTIONALISIERTE KOHLENSTOFFNANOCONSPITZE UND HERSTELLUNGSVERFAHREN DAFÜR
POINTE DE NANOCÔNE DE CARBONE FONCTIONNALISÉ ET SON PROCÉDÉ DE PRÉPARATION

(43) Date of publication of application: 05.04.2023
(73) Proprietor: National Center For Nanoscience And Technology, Beijing 100190 (CN)
(72) Inventor: XU, Jianxun, Beijing 100190 (CN); ZHAO, Yuliang, Beijing 100190 (CN); GE, Yifei, Beijing 100190 (CN); LU, Mingming, Beijing 100190 (CN); WANG, Jiahao, Beijing 100190 (CN)
(74) Representative: Wallinger, Michael
(86) International application number: PCT/CN2021/072144
(87) International publication number: WO 2022/151349

(56) References cited:
- CN-A- 101 049 906
- CN-A- 101 538 031
- CN-A- 105 712 281
- CN-A- 108 658 037
- CN-A- 110 323 457
- US-A1- 2002 006 489
- US-A1- 2019 107 556
- US-B1- 7 828 622
- KRISHNAN A: "Graphitic cones and the nucleation of curved carbon surfaces", NATURE, vol. 388, 1 January 1997 (1997-01-01), pages 451 - 454, XP093059940, Retrieved from the Internet <URL:https://www.nature.com/articles/41284.pdf> [retrieved on 20230701]
- HUANG WEI ET AL: "Tapered carbon nanocone tips obtained by dynamic oxidation in air", RSC ADVANCES, vol. 6, no. 30, 1 January 2016 (2016-01-01), pages 25541 - 25548, XP055890417, DOI: 10.1039/C5RA25667D
- XU LELE: "The Fabrication and Functionalizational Modification of Carbon Nanocone(CNC) Tips", MASTER THESIS, TIANJIN POLYTECHNIC UNIVERSITY, CN, 15 June 2019 (2019-06-15), CN , XP055950218, ISSN: 1674-0246

## Description

### TECHNICAL FIELD

The present application relates to the technical field of metal material functionalization, and in particular to a preparation method for a functionalized carbon nanocone needle tip.

### BACKGROUND

Electron emission source is a core component of a vacuum electronic equipment, which is widely used in X-ray source, microwave source, mass spectrometer ionization chamber, field emission display and other fields. An electron source with high brightness and large beam current can be used as a light source of electron microscope, electron beam lithography equipment and so on.

In recent years, the rapid development of materials science and nanotechnology has greatly promoted the research of new electron emission sources ^{[1-3]}. Carbon nanotube was widely expected to be used as field emission electron source due to its special structure and properties. Preliminary results, represented by the work of De Jonge et al., show that the carbon nanotube needle tip can obtain an electron beam with high-brightness and good-monochromatic at a lower deposition voltage ^{[4,5]}. However, the preparation method of carbon nanotube needle tip has low controllability, which cannot ensure the structure and orientation of a tip of the carbon nanotube (effective electron emission site). In addition, the physical adhesion connection between carbon nanotube and metal W needle tip body is not firm. These problems lead to that the carbon nanotube needle tip cannot be used as a practical electron gun. In 2016, Zhang et al. from Japan National Institute for Material Science prepared LaB₆ single crystal nanowire and characterized the field emission properties thereof, showing excellent electron beam monochromaticity and emission stability ^{[2]}. However, similar to carbon nanotube, it is difficult to ensure the orientation of a tip of the nanowire and the mechanical and electrical properties of the interface structure between the nanowire and a metal needle tip body during the preparation of assembling one-dimensional nanowire into the metal needle tip body. In 2018, Khursheed's group from Singapore National University used chemical vapor deposition to grow graphene on the surface of a Ni needle tip and the results show the extremely low surface work function and high electron beam brightness of the functionalized needle tip ^{[6]}. However, since it is impossible to avoid the presence of a large number of structural defects when growing graphene on the surface (non-single crystal face) of the tip of the Ni needle tip, the electron emission beam of the functionalized needle tip has poor stability and large noise (about 30%). In summary, nanomaterials provide abundant materials for the development of electron guns. However, in order to realize the application of nanomaterials functionalized electron guns, it is necessary to realize the precise control for the needle tip preparation method to ensure the performance of the interface structure, the orientation of the tip of the needle tip, the integrity and cleanliness of the crystal structure of the tip.

The preparation methods of nanomaterials functionalized needle tip are mainly divided into two categories, namely direct growth method and micro-nano assembly method. The direct growth method is to directly synthesize nanomaterials on a needle tip base, which cannot control the length, diameter, orientation and other parameters of nanomaterials. The micro-nano assembly method is to control the precise movement of the probe by operating a high-precision three-dimensional manipulation device under a microscope to realize the assembly of specific nanomaterials and a needle tip base, which has high controllability and is more conducive to controlling the structure and orientation of nanomaterials. The inventor of the present application prepared a conical nano-carbon material functionalized needle tip by a combined method of micro-nano manipulation and in-situ current heating (see Chinese patent ZL201610091160.0, and US patent US10823758B2). Compared with the previous nanomaterials functionalized needle tip, this conical nano-carbon material functionalized needle tip can ensure that the orientation of the tip of the nanomaterials needle tip is completely consistent with the axial direction of the needle tip base, and the interface between the nanomaterials and the needle tip base has excellent mechanical strength and electrical conductivity.

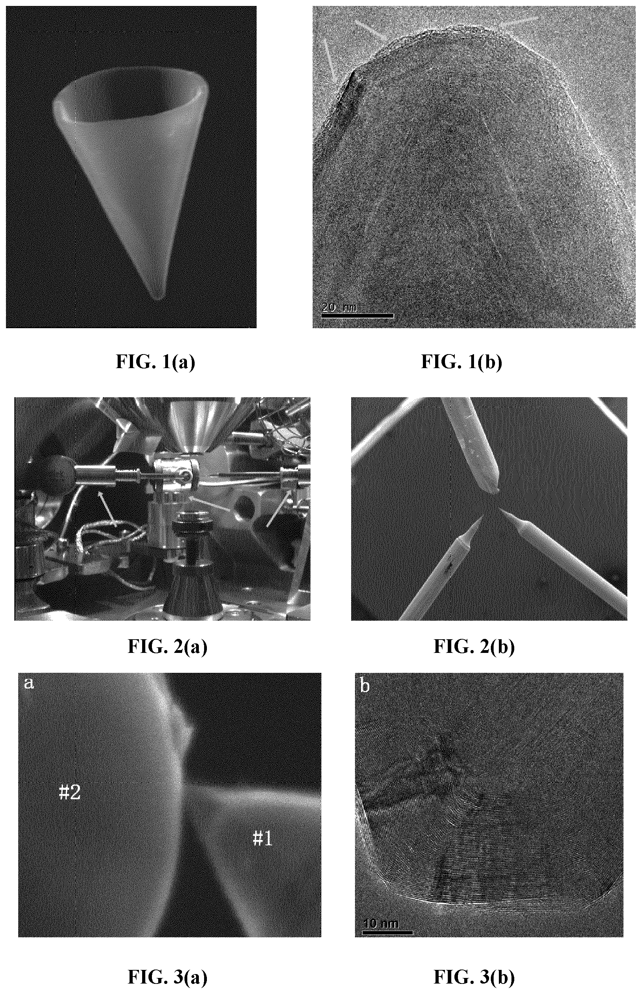

As stated above, it is necessary to ensure that the surface of the tip of the electron gun needle tip must be free of contaminants and structural defects. Contaminants and structural defects will cause that the electron beam emission is uncontrollable and has poor stability and even an invalidation of electron gun. The synthesis, preservation and micro-nano assembly of carbon nanocone cannot avoid the presence (as shown in FIG. 1) of surface contaminants (mainly amorphous carbon, hydrocarbons, etc.). Therefore, the purification of carbon nanocone needle tip is necessary for its application in electron source. The published patents mentioned above do not include the purification method of the apex of the carbon nanocone needle. Common purification treatment methods, such as air oxidation method, wet hydrogen treatment method, etc., will produce a large number of structural defects while removing the contaminants on the surface of the carbon nanocone ^{[7]}. So far, there is no report on a method of obtaining clean carbon nanocone needle tip with complete structure on tip.

References:
1. De Jonge, N.; Lamy, Y.; Schoots, K.; Oosterkamp, T. H.: High brightness electron beam from a multi-walled carbon nanotube. Nature 2002, 420, 393-395.
2. Zhang, H.; Tang, J.; Yuan, J.; Yamauchi, Y.; Suzuki, T. T.; Shiya, N.; Nakajima, K.; Qin, L.-C.: An ultrabright and monochromatic electron point source made of a LaB6 nanowire. Nature Nanotechnology 2015.
3. Narasimha, K. T.; Ge, C.; Fabbri, J. D.; Clay, W.; Tkachenko, B. A.; Fokin, A. A.; Schreiner, P. R.; Dahl, J. E.; Carlson, R. M. K.; Shen, Z.; Melosh, N. A.: Ultralow effective work function surfaces using diamondoid monolayers. Nature Nanotechnology 2015.
4. De Jonge, N.: Carbon Nanotube Electron Sources for Electron Microscopes. Adv Imag Elect Phys 2009, 156, 203-233.
5. De Jonge, N.; Bonard, J. M.: Carbon nanotube electron sources and applications. Philos T R Soc A 2004, 362, 2239-2266.
6. Shao, X. Y.; Srinivasan, A.; Ang, W. K.; Khursheed, A.: A high-brightness largediameter graphene coated point cathode field emission electron source. Nature Communications 2018, 9, 1288.
7. Huang, W.; Xu, J.X.; Lu, X.: Tapered carbon nanocone needle tips obtained by dynamic oxidation in air. RSC Adv. 2016, 6, 25541.

The US 2019/107556 A1 describes a conical nano-carbon material functionalized needle tip, formed by assembling a nano-carbon material with a material of a needle tip by means of a covalent bond; and the material of the needle tip is a metal selected from one or more of tungsten, iron, cobalt, nickel and titanium. Further described is a method for preparing the conical nanocarbon material functionalized needle tip. The conical nano-material functionalized needle tip has an outstanding interface formed by metal-carbide covalent bonds, and the orientation of the conical nano-material is matched with the axial direction of the metal needle tip.

### SUMMARY

The present application aims to solve at least one of the problems in the related art.

The invention is set out in the appended set of claims.

### BRIEF DESCRIPTION OF THE DRAWINGS

In the following description any use of the term embodiment is understood to refer to an example which is given as an aid for understanding the invention. The invention is defined by the claims.
FIG. 1(a) is an overall structure diagram of a carbon nanocone provided by an embodiment of the present application.
FIG. 1(b) is a high-resolution transmission electron microscope photograph of an apex of a carbon nanocone provided by an embodiment of the present application, showing a layered graphite structure of the carbon nanocone, where arrows in this figure indicate contaminants on a surface of the carbon nanocone.
FIG. 2(a) is a side view of a metal needle tip installed on a micro-nano manipulator in a scanning electron microscope, where arrows are marked as three micro-nano manipulators.
FIG. 2(b) is a top view of a metal needle tip installed on a micro-nano manipulator in a scanning electron microscope.
FIG. 3(a) is a scanning electron microscope photograph of a tip of a functionalized carbon nanocone needle tip (#1) in contact with a metal body (#2).
FIG. 3(b) is a transmission electron microscope photograph of a clean apex of a carbon nanocone after instantaneous current treatment.
FIG. 4(a) is a scanning electron microscope photograph of a side surface of a functionalized carbon nanocone needle tip (#1) in contact with a metal body (#2).
FIG. 4(b) is a transmission electron microscope photograph of a clean apex of a carbon nanocone after instantaneous current treatment.
FIG. 4(c) is a field emission curve graph of a prepared functionalized carbon nanocone needle tip.
FIG. 4(d) is an electron microscope photograph of a field emission test by applying an electric field between a functionalized carbon nanocone needle tip (#1) and an anode (#3).
FIG. 5(a) is a scanning electron microscope photograph of a functionalized carbon nanocone needle tip provided by an embodiment of the present application.
FIG. 5(b) is a structural view of a clean and complete graphite layer of a carbon nanocone provided by an embodiment of the present application.
FIG. 6(a) is a scanning electron microscope photograph of a functionalized carbon nanocone needle tip provided by an embodiment of the present application.
FIG. 6(b) is a structural view of a clean and complete graphite layer of a carbon nanocone provided by an embodiment of the present application.

### DETAILED DESCRIPTION

In order to explain the objectives, solutions, and advantages of the present application more clearly, the solutions according to the present application will be clearly and completely described below in conjunction with the drawings in the present application. It should be noted that, the described embodiments are part of embodiments of the present application, rather than all of the embodiments. Based on the embodiments in the present application, all other embodiments obtained by those of ordinary skill in the art without creative work are within the scope of protection of the present application.

FIG. 1(a) is an overall structure diagram of a carbon nanocone provided by an embodiment of the present application. FIG. 1(b) is a high-resolution transmission electron microscope photograph of an apex of a carbon nanocone provided by an embodiment of the present application. As shown in FIG. 1(a) and FIG. 1(b), the present application provides a functionalized carbon nanocone needle tip, where a front end of a needle tip base is modified by a carbon nanocone.

The carbon nanocone is a conical nanocarbon material composed of a layered graphite structure. The material of the needle tip base is metal, which is selected from one or more of tungsten, iron, cobalt, nickel and titanium. A tail end of the carbon nanocone forms an interface connection of covalent bonds with the needle tip base, and an orientation of a tip is consistent with a central axis orientation of a needle tip. A surface of the apex of the carbon nanocone is clean and has complete graphite layer structure without contaminants and damage.

The present application further provides a preparation and purification method for the functionalized carbon nanocone needle tip.

The assembly of carbon nanocone and metal needle tip base adopts the method disclosed in the published patent ZL201610091160.0. Under an electron microscope, a micro-nano manipulator is used to control a front end of the metal needle tip base to extend into an inside of the carbon nanocone to adhere the carbon nanocone to the front end of the needle tip base. After that, the needle tip base is in contact with a metal body, and a voltage is applied between the metal body and the needle tip base to make a current pass through the needle tip base, and then the front end of the needle is heated and combined with the adhered carbon nanocone. In an embodiment, a distance between a position where the metal body contacted with the needle tip base and a top of the needle tip is 0.2 ~ 100 µm, and the current through the needle tip base is 0.01 ~ 5A.

The purification method provided by the present application refers to a removal of contaminants such as amorphous carbon and hydrocarbons on a surface of the carbon nanocone by instantaneous current ablation or selective chemical reaction.

Preparation of functionalized carbon nanocone needle tip by instantaneous current ablation includes the following steps:
S101, a carbon nanocone is assembled at a front end of a needle tip base by using a micro-nano manipulation method combined with an in-situ current heating method; and
S102, a needle body is contacted with a metal body, and an instantaneous current is applied between the needle body and the metal body to remove an external graphite layer of the carbon nanocone together with contaminants.

In an embodiment, in S102, the needle body and the metal body are fixed on the micro-nano manipulator, and they are controlled by the micro-nano manipulator to move under a microscope observation, as shown in FIG. 2(a) and FIG. 2(b).

In an embodiment, S102 further includes: the apex of the carbon nanocone of the needle body is controlled to contact with the metal body to form an electrical path, where the instantaneous current is 0.01 ~ 10 mA.

In an embodiment, S102 further includes: a side surface of the carbon nanocone of the needle body is controlled to contact with the metal body to form an electrical path, where a distance between a position where the metal body contacted with the needle body and the top of the needle tip is 0.01 ~ 1 µm, and the instantaneous current is 1 ~ 100 mA.

In a preferred embodiment, a possible mechanism of removing the external graphite layer of the carbon nanocone by instantaneous current is as follows. Since the carbon nanocone has a multi-layer graphite structure, an inter-layer resistivity (10⁻³ Ω • m) of graphite is 1000 times that of an intra-layer resistivity (10⁻⁶ Ω • m). Therefore, an instantaneous current will pass through an external graphite layer firstly and break the carbon-carbon bond inside layers. Cooperated with a Joule heat generated by the instantaneous current, the external graphite layer together with surface contaminants are cracked and volatilized into vacuum, and finally a clean internal graphite layer structure is obtained. In this embodiment, S102 can be repeated several times to controllably remove a certain number of external graphite layers to obtain a clean functionalized carbon nanocone needle tip with a sharper tip.

Preparation of functionalized carbon nanocone needle tip by selective chemical reaction includes the following steps:
S201, a carbon nanocone is assembled at a front end of a needle tip base by using micro-nano manipulation method combined with in-situ current heating method; and
S202, a needle tip is heated to a target temperature and an active substance is introduced to make the active substance selectively react with contaminants on a surface of the needle tip to purify a functionalized carbon nanocone needle tip; where the active substance is a weak oxidant, such as carbon dioxide or water.

In an embodiment, in S202, a needle body and a metal body are fixed on the micro-nano manipulator, and they are controlled by the micro-nano manipulator to move under a microscope observation, as shown in FIG. 2(a) and FIG. 2(b).

In an embodiment, S202 further includes: a side surface of the needle body is controlled to contact with the metal body, and a continuous current is applied between the needle body and the metal body, and then the tip of the needle tip reaches a local high temperature and reacts with the active substance. Preferably, a distance between a position where the metal body contacted with the needle body and the top of the needle tip is 0.2 ~ 100 µm, and the current through the needle body is 0.01 ~ 5 A. The weak oxidant, such as carbon dioxide or water vapor, is introduced into a sample chamber of scanning electron microscope through a gas path control valve of environmental scanning electron microscope, and a pressure range of active gas in the sample chamber of scanning electron microscope is 10 ~ 2 000 Pa.

In an embodiment, S202 further includes: the needle tip is installed on a needle tip clamping device and putted into a vacuum tube furnace, contaminants on the surface of needle tip are removed by introducing carbon dioxide or water vapor and heating it to a target temperature. In an embodiment, a flow rate of carbon dioxide or water vapor is 100 ~ 1000 sccm, a heating rate is 1 ~ 10 °C/min, a target temperature is 450 °C ~ 750 °C, and a holding time is 30 ~ 600 min.

In an embodiment, the contaminants of amorphous carbon and hydrocarbon on the surface of the carbon nanocone have higher chemical reactivity than the graphite structure of the carbon nanocone, and preferentially react with various oxidants to convert into gas products to achieve the purpose of purifying the surface. In order to avoid introducing defects in the graphite structure of the carbon nanocone while removing surface contaminants, soft oxidants such as carbon dioxide or water vapor are used in the solutions provided by the present application. Carbon dioxide reacts with amorphous carbon and hydrocarbon to generate carbon monoxide, and water vapor reacts with amorphous carbon and hydrocarbon to generate carbon monoxide and hydrogen, and then a clean carbon nanocone needle tip with a complete graphite structure is finally obtained.

The following specific embodiments are given to illustrate the solutions of the present application. Where no specific technology or conditions are specified in the embodiments, it shall be performed according to the technology or conditions described in the literature in this field, or according to the product description. Reagents or instruments used that do not specify the manufacturer are conventional products that can be purchased through formal channels.

In the following specific embodiments, Kleindiek Nanotechnik's products are used as the micro-nano manipulator, Thermo Fisher's Quanta 200 scanning electron microscope is used as the scanning electron microscope, and Thermo Fisher's F20 transmission electron microscope is used as the transmission electron microscope.

### Embodiment 1

In this embodiment, two tungsten needles are fixed on two micro-nano manipulators respectively; both the micro-nano manipulators and carbon nanocone samples are placed in a scanning electron microscope. Firstly, a tungsten needle (#2) is made close to the side wall of a #1 metal tungsten needle tip base from 50 µm away from the top of the #1 metal tungsten needle tip base, and then a 60 V voltage is applied between the #1 and the #2 to generate an electric arc which causes a top of the #2 tungsten needle to melt into a sphere.

The tip of the #1 needle is inserted into a conic top of a selected carbon nanocone and contacts with the carbon nanocone, and adheres to a top of the needle tip. After that, the sphere at the top of the #2 tungsten needle contacts a side surface of the tungsten needle tip (#1) at a distance of 2 µm from the top of the needle tip #1. A voltage is applied on the two tungsten needle tips to generate a current of 2 A, and the duration of the current is 0.1 ms. The top of the metal tungsten needle tip (#1) melts, and the molten metal tungsten automatically enters and fills an internal space of the carbon nanocone to obtain the #1 functionalized needle tip shown in FIG. 3 (a).

The #1 functionalized carbon nanocone needle tip is moved to contact the tip of it with the sphere at the top of the #2 tungsten needle. An instantaneous current of 1 mA is applied, and the duration of the current is 0.5 µs. After electrification, the carbon nanocone needle tip is quickly removed and an electron beam is avoided from irradiating the needle tip surface. For the removed carbon nanocone needle tip, its morphology was observed under transmission electron microscope, and the clean and undamaged tip of the needle tip of the graphite layer shown in FIG. 3(b) is obtained.

### Embodiment 2

In this embodiment, two tungsten needles are fixed on two micro-nano manipulators respectively; both the micro-nano manipulators and carbon nanocone samples are placed in a scanning electron microscope. Firstly, a tungsten needle (#2) is made close to the side wall of a #1 metal tungsten needle tip base from 50 µm away the top of the #1 metal tungsten needle tip base, and then a 60 V voltage is applied between the #1 and the #2 to generate an electric arc which causes a top of the #2 tungsten needle to melt into a sphere.

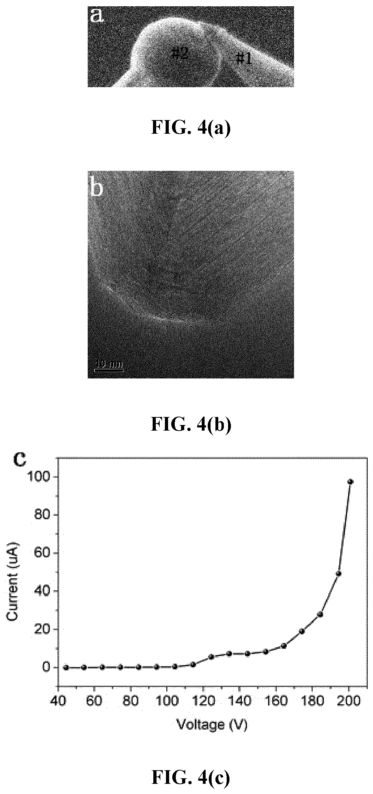

The tip of the #1 needle tip is inserted into a conic top of a selected carbon nanocone and contacts with the carbon nanocone, and adheres to a top of the needle tip. After that, the sphere at the top of the #2 tungsten needle contacts a side surface of the tungsten needle tip (#1) at a distance of 3 µm from the top of the needle tip #1. A voltage is applied on the two tungsten needles to generate a current of 3 A, and the duration of the current is 0.1 ms. The top of the metal tungsten needle (#1) melts, and the molten metal tungsten automatically enters and fills an internal space of the carbon nanocone to obtain the #1 functionalized needle tip shown in FIG. 4(a).

The #1 functionalized carbon nanocone needle tip is moved to contact the side surface of it with the sphere at the top of the #2 tungsten needle. An instantaneous current of 20 mA is applied, and the duration of the current is 0.5 µs. After electrification, the #1 carbon nanocone needle tip is quickly removed and an electron beam is avoided from irradiating the needle tip surface. For the removed carbon nanocone needle tip, its morphology was observed under transmission electron microscope, and the clean and undamaged tip of the needle tip of the graphite layer shown in FIG. 4(b) is obtained.

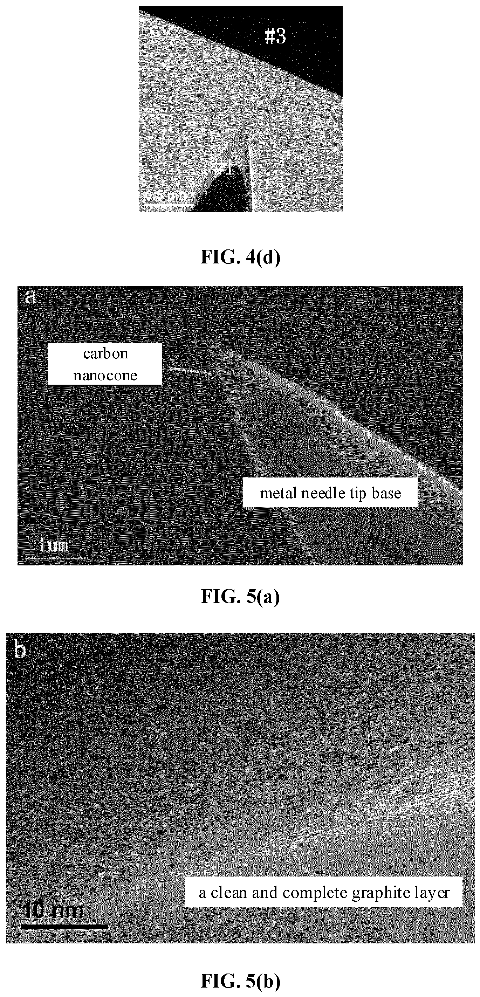

By using a driving device on a sample rod of an in-situ transmission electron microscope, the #1 functionalized carbon nanocone needle tip is moved close to a surface of a #3Au electrode by about 500 nm, as shown in FIG. 4(d). A continuously changing voltage (40-200 V) is applied between the Au electrode (anode) and the functionalized carbon nanocone needle tip (cathode) and a corresponding current is recorded to obtain a field emission curve, as shown in FIG. 4(c). It can be seen that the functionalized carbon nanocone needle tip prepared by the present application can provide a large beam emission of 100 µA.

### Embodiment 3

In this embodiment, two tungsten needles are fixed on two micro-nano manipulators respectively; both the micro-nano manipulators and carbon nanocone samples are placed in a scanning electron microscope. Firstly, a tungsten needle (#2) is made close to the side wall of a #1 metal tungsten needle tip base from 50 µm away from the top of the #1 metal tungsten needle tip base, and then a 60 V voltage is applied between the #1 and the #2 to generate an electric arc which causes a top of the #2 tungsten needle to melt into a sphere.

The tip of the #1 needle is inserted into a conic top of a selected carbon nanocone and contacts with the carbon nanocone, and adheres to a top of the needle tip. After that, the sphere at the top of the #2 tungsten needle contacts a side surface of the tungsten needle tip (#1) at a distance of 3 µm from the top of the needle tip #1. A voltage is applied on the two tungsten needle tips to generate a current of 3 A, and the duration of the current is 0.1 ms. The top of the metal tungsten needle tip (#1) melts, and the molten metal tungsten automatically enters and fills an internal space of the carbon nanocone to obtain the #1 functionalized needle tip shown in FIG. 5(a).

The electron microscope is switched to an environmental scanning electron microscope mode, and carbon dioxide atmosphere is introduced. A carbon dioxide pressure in the sample chamber is controlled to 1000 Pa by a pressure regulating valve of the electron microscope. A contact position between the sphere of #2 tungsten needle and the side surface of #1 carbon nanocone needle tip remains unchanged. A current of 0.6 A is applied on the two needle bodies for 10 min. After heating, the functionalized carbon nanocone needle tip is quickly removed to avoid electron beam irradiation. After the electron microscope is switched back to a high vacuum mode, nitrogen is introduced in and the carbon nanocone needle tip is taken out. A high-resolution morphology of the carbon nanocone needle tip is observed by transmission electron microscopy. As shown in FIG. 5(b), the carbon nanocone has a clean and complete graphite layer structure.

### Embodiment 4

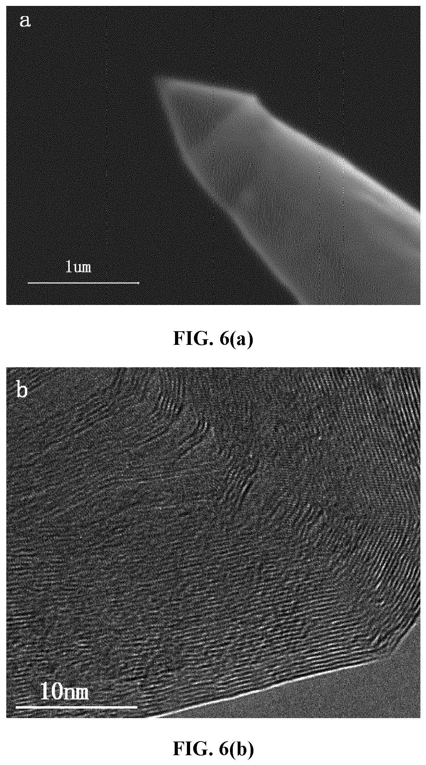

In this embodiment, the preparation method of the functionalized carbon nanocone needle tip (shown in FIG. 6(a)) is the same as that in embodiment 3.

The functionalized carbon nanocone needle tip is fixed on a needle tip clamping device made of ceramic material and the needle tip is upward, and then the needle tip clamping device is placed in heating area of a vacuum tube furnace. A target temperature of the tube furnace is set to 500 °C, a heating rate is 1 °C/min, and a holding time is 60 min. Before heating, carbon dioxide is introduced into the tube furnace, and a flow rate of carbon dioxide is 500 sccm. After the heating is completed, it is naturally cooled to a room temperature, and nitrogen is introduced. The carbon nanocone needle tip is taken out to observe its structural characteristics under a transmission electron microscope, as shown in FIG. 6(b).

## Claims

1. A preparation method for a functionalized carbon nanocone needle tip, comprising the following steps:
S201, assembling a carbon nanocone at a front end of a needle tip base; and **characterized by**
S202, heating the needle tip to a target temperature and introducing an active substance to make the active substance selectively react with contaminants on a surface of the needle tip to purify a functionalized carbon nanocone needle tip, wherein the active substance is a weak oxidant.

2. The preparation method for the functionalized carbon nanocone needle tip according to claim 1, wherein the weak oxidant is carbon dioxide or water.

3. The preparation method for the functionalized carbon nanocone needle tip according to claim 1, wherein in S202, a needle body and a metal body are fixed on the micro-nano manipulators, and the needle body and the metal body are controlled to move by the micro-nano manipulators under a microscope observation.

4. The preparation method for the functionalized carbon nanocone needle tip according to claim 3, wherein S202 further comprises:
contacting a side surface of the needle body with the metal body, and applying a continuous current between the needle body and the metal body, to make a tip of the needle tip reach a local high temperature and react with the active substance.

5. The preparation method for the functionalized carbon nanocone needle tip according to claim 1, wherein S202 further comprises:
installing the needle tip on a needle tip clamping device, putting the needle tip clamping device into a vacuum tube furnace, introducing carbon dioxide or water vapor and heating it to a target temperature to remove contaminants on the needle tip surface.

6. The preparation method for the functionalized carbon nanocone needle tip according to claim 1, wherein the assembling the carbon nanocone at the front end of the needle tip base comprises:
controlling, by using a micro-nano manipulator, the front end of the needle tip base to extend into an interior of the carbon nanocone to make the carbon nanocone adhere to the front end of the needle tip base, contacting the needle tip base with the metal body, and applying a voltage between the metal body and the needle tip base to make a current pass through the needle tip base, and then the front end of the needle tip base is heated and combined with an adhered carbon nanocone.

7. The preparation method for the functionalized carbon nanocone needle tip according to claim 1, wherein a front end of a needle tip base is modified by a carbon nanocone;
wherein the carbon nanocone is a conical nanocarbon material composed of a layered graphite structure; a material of the needle tip base is metal which is selected from one or more of tungsten, iron, cobalt, nickel and titanium; a tail end of the carbon nanocone forms an interface connection of covalent bonds with the needle tip base, and an orientation of a tip is consistent with a central axis orientation of a needle tip;
wherein a tip surface of the carbon nanocone is clean and a graphite layer structure is complete.

## Patentansprüche

1. Verfahren zur Herstellung einer funktionalisierten Kohlenstoff-Nanokegel-Nadelspitze, welches die folgenden Schritte umfasst:
S201, ein Zusammenbauen eines Kohlenstoff-Nanokegels an einem vorderen Ende einer Nadelspitzenbasis; und **gekennzeichnet durch**
S202, ein Erhitzen der Nadelspitze auf eine Zieltemperatur und ein Einbringen einer aktiven Substanz, um die aktive Substanz selektiv mit Verunreinigungen auf einer Oberfläche der Nadelspitze reagieren zu lassen, um eine funktionalisierte Kohlenstoff-Nanokegel-Nadelspitze zu reinigen, wobei die aktive Substanz ein schwaches Oxidationsmittel ist.

2. Verfahren zur Herstellung der funktionalisierten Kohlenstoff-Nanokegel-Nadelspitze nach Anspruch 1, wobei das schwache Oxidationsmittel Kohlendioxid oder Wasser ist.

3. Verfahren zur Herstellung der funktionalisierten Kohlenstoff-Nanokegel-Nadelspitze nach Anspruch 1, wobei in dem Schritt S202 ein Nadelkörper und ein Metallkörper auf den Mikro-Nano-Manipulatoren befestigt werden und der Nadelkörper und der Metallkörper so gesteuert werden, dass sie sich unter mikroskopischer Beobachtung durch die Mikro-Nano-Manipulatoren bewegen.

4. Verfahren zur Herstellung der funktionalisierten Kohlenstoff-Nanokegel-Nadelspitze nach Anspruch 3, wobei der Schritt S202 ferner umfasst:
ein In-Kontakt-Bringen einer Seitenfläche des Nadelkörpers mit dem Metallkörper und ein Anlegen eines Dauerstroms zwischen dem Nadelkörper und dem Metallkörper, um eine Spitze der Nadelspitze auf eine lokal hohe Temperatur zu bringen und mit der aktiven Substanz reagieren zu lassen.

5. Verfahren zur Herstellung der funktionalisierten Kohlenstoff-Nanokegel-Nadelspitze nach Anspruch 1, wobei der Schritt S202 ferner umfasst:
ein Anbringen der Nadelspitze an einer Nadelspitzen-Klemmvorrichtung, ein Einbringen der Nadelspitzen-Klemmvorrichtung in einen Vakuumrohr-Ofen, ein Einleiten von Kohlendioxid oder Wasserdampf und ein Erhitzen auf eine Zieltemperatur, um Verunreinigungen auf der Nadelspitzenoberfläche zu entfernen.

6. Verfahren zur Herstellung der funktionalisierten Kohlenstoff-Nanokegel-Nadelspitze nach Anspruch 1, wobei das Anbringen des Kohlenstoff-Nanokegels an dem vorderen Ende der Nadelspitzenbasis umfasst:
ein Steuern des vorderen Endes der Nadelspitzenbasis mittels eines Mikro-Nano-Manipulators, um diese in das Innere des Kohlenstoff-Nanokegels hinein zu verlängern, um den Kohlenstoff-Nanokegel an dem vorderen Ende der Nadelspitzenbasis haften zu lassen, ein In-Kontakt-Bringen der Nadelspitzenbasis mit dem Metallkörper und ein Anlegen einer Spannung zwischen dem Metallkörper und der Nadelspitzenbasis, um einen Strom durch die Nadelspitzenbasis fließen zu lassen, und dann wird das vordere Ende der Nadelspitzenbasis erhitzt und mit einem anhaftenden Kohlenstoff-Nanokegel verbunden.

7. Verfahren zur Herstellung der funktionalisierten Kohlenstoff-Nanokegel-Nadelspitze nach Anspruch 1, wobei ein vorderes Ende einer Nadelspitzenbasis durch einen Kohlenstoff-Nanokegel modifiziert wird;
wobei der Kohlenstoff-Nanokegel ein konisches Nanokohlenstoffmaterial ist, das aus einer geschichteten Graphitstruktur besteht; ein Material der Nadelspitzenbasis ein Metall ist, das aus einem oder mehreren der folgenden Materialien ausgewählt worden ist: Wolfram, Eisen, Kobalt, Nickel und Titan; ein hinteres Ende des Kohlenstoff-Nanokegels eine Grenzflächenverbindung aus kovalenten Bindungen mit der Nadelspitzenbasis bildet und eine Ausrichtung einer Spitze mit einer Mittelachsenausrichtung einer Nadelspitze übereinstimmt;
wobei eine Spitzenoberfläche des Kohlenstoff-Nanokegels sauber ist und eine Graphitschichtstruktur vollständig ist.

## Revendications

1. Procédé de préparation pour une pointe d'aiguille en nanocône de carbone fonctionnalisé, comprenant les étapes suivantes :
S201, l'assemblage d'un nanocône de carbone au niveau d'une limite avant d'une base de pointe d'aiguille ; et **caractérisé par**
S202, le chauffage de la pointe d'aiguille à une température cible et l'introduction d'une substance active pour faire réagir sélectivement la substance active avec des contaminants sur une surface de la pointe d'aiguille afin de purifier une pointe d'aiguille en nanocône de carbone fonctionnalisé, dans lequel la substance active est un oxydant faible.

2. Procédé de préparation pour la pointe d'aiguille en nanocône de carbone fonctionnalisé selon la revendication 1, dans lequel l'oxydant faible est du dioxyde de carbone ou de l'eau.

3. Procédé de préparation pour la pointe d'aiguille en nanocône de carbone fonctionnalisé selon la revendication 1, dans lequel dans S202, un corps d'aiguille et un corps métallique sont fixés sur les micro/nano-manipulateurs, et les déplacements du corps d'aiguille et du corps métallique sont commandés par les micro/nano-manipulateurs avec observation au microscope.

4. Procédé de préparation pour la pointe d'aiguille en nanocône de carbone fonctionnalisé selon la revendication 3, dans lequel S202 comprend en outre :
la mise en contact d'une surface latérale du corps d'aiguille avec le corps métallique, et l'application d'un courant continu entre le corps d'aiguille et le corps métallique, pour faire en sorte qu'une extrémité de la pointe d'aiguille atteigne une température locale élevée et réagisse avec la substance active.

5. Procédé de préparation pour la pointe d'aiguille en nanocône de carbone fonctionnalisé selon la revendication 1, dans lequel S202 comprend en outre :
l'installation de la pointe d'aiguille sur un dispositif de serrage de pointe d'aiguille, le placement du dispositif de serrage de pointe d'aiguille dans un four à tube sous vide, l'introduction de dioxyde de carbone ou de vapeur d'eau et leur chauffage à une température cible pour éliminer les contaminants sur la surface de la pointe d'aiguille.

6. Procédé de préparation pour la pointe d'aiguille en nanocône de carbone fonctionnalisé selon la revendication 1, dans lequel l'assemblage du nanocône de carbone au niveau de la limite avant de la base de pointe d'aiguille comprend :
la commande, à l'aide d'un micro/nano-manipulateur, de la limite avant de la base de pointe d'aiguille pour l'avancer à l'intérieur du nanocône de carbone afin de faire adhérer le nanocône de carbone à la limite avant de la base de pointe d'aiguille, la mise en contact de la base de pointe d'aiguille avec le corps métallique, et l'application d'une tension entre le corps métallique et la base de pointe d'aiguille pour faire passer un courant à travers la base de pointe d'aiguille, et ainsi la limite avant de la base de pointe d'aiguille est chauffée et combinée avec un nanocône de carbone adhéré.

7. Procédé de préparation pour la pointe d'aiguille en nanocône de carbone fonctionnalisé selon la revendication 1, dans lequel une limite avant d'une base de pointe d'aiguille est modifiée par un nanocône de carbone ;
dans lequel le nanocône de carbone est un matériau de nanocarbone conique composé d'une structure en couches de graphite ; un matériau de la base de pointe d'aiguille est du métal qui est choisi parmi un ou plusieurs éléments parmi le tungstène, le fer, le cobalt, le nickel et le titane ; une limite arrière du nanocône de carbone forme une jonction d'interface de liaisons covalentes avec la base de pointe d'aiguille, et une orientation d'une extrémité est cohérente avec une orientation d'axe central d'une pointe d'aiguille ;
dans lequel une surface de pointe du nanocône de carbone est propre et une structure en couches de graphite est intégrale.
